(19) Europäisches Patentamt / European Patent Office / Office européen des brevets

(11) **EP 2 240 318 B1**

(12) **FASCICULE DE BREVET EUROPEEN**

(45) Date de publication et mention
de la délivrance du brevet:
**06.07.2011 Bulletin 2011/27**

(51) Int Cl.:
*B32B 17/10* (2006.01)  *H01C 7/00* (2006.01)
*H01C 17/065* (2006.01)  *H05B 3/84* (2006.01)
*H05K 1/16* (2006.01)  *H05K 3/00* (2006.01)

(21) Numéro de dépôt: **09708987.4**

(22) Date de dépôt: **26.01.2009**

(86) Numéro de dépôt international:
**PCT/FR2009/050111**

(87) Numéro de publication internationale:
**WO 2009/098421 (13.08.2009 Gazette 2009/33)**

(54) **PROCEDE DE FABRICATION D'UN ELEMENT CHAUFFANT PAR DEPOT DE COUCHES MINCES SUR UN SUBSTRAT ISOLANT, L'ELEMENT OBTENU ET SON UTILISATION**

VERFAHREN ZUR HERSTELLUNG EINES ERWÄRMUNGSELEMENTS DURCH ABLAGERUNG DÜNNER SCHICHTEN AUF EINEM ISOLATIONSSUBSTRAT, DARAUS RESULTIERENDES ELEMENT UND BENUTZUNG DES LETZTEN

METHOD FOR MAKING A HEATING ELEMENT BY DEPOSITING THIN LAYERS ONTO AN INSULATING SUBSTRATE, THE RESULTING ELEMENT AND USE THEREOF

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **06.02.2008 FR 0850747**

(43) Date de publication de la demande:
**20.10.2010 Bulletin 2010/42**

(73) Titulaire: **H.E.F.**
**42160 Andrezieux-Boutheon (FR)**

(72) Inventeurs:
• **MAURIN-PERRIER, Philippe**
**F-42680 Saint-Marcellin-en-Forez (FR)**
• **HEAU, Christophe**
**F-42100 Saint-Etienne (FR)**
• **TERME, Benoît**
**F-42700 Firminy (FR)**

(74) Mandataire: **Thivillier, Patrick et al**
**Cabinet Laurent & Charras**
**3 Place de l'Hôtel de Ville**
**B.P. 203**
**42005 Saint-Etienne Cedex 1 (FR)**

(56) Documents cités:
WO-A-2005/107348    GB-A- 499 816
GB-A- 2 128 813    US-A- 2 111 742
US-A- 2 419 537    US-A- 3 095 340
US-A- 3 458 847    US-A- 3 594 225
US-A- 3 772 075    US-A- 5 643 483
US-A1- 2006 163 563

**Description**

L'invention concerne le domaine technique du dépôt des couches minces pour réaliser des éléments chauffants sur substrat isolant.

L'invention trouve une application avantageuse dans le domaine du désembuage ou du dégivrage de surfaces, dans des secteurs comme par exemple des surfaces réfléchissantes dans le secteur automobile ou le bord d'attaque d'ailes dans le secteur aéronautique.

D'une manière connue pour un homme du métier, un élément chauffant est constitué d'une zone caractérisée par une résistance électrique faible dite zone froide et par une zone de résistance électrique beaucoup plus élevée pour constituer la partie chauffante en tant que telle.

Dans une conception des éléments chauffants, deux zones froides sont associées à la zone chauffante par un montage en série, de sorte que l'intensité électrique qui traverse chacune des zones est la même.

Les zones froides ont pour fonction de connecter les arrivées électriques provenant d'une source extérieure et de distribuer le courant, de façon homogène, aux bornes de la partie chauffante.

Etant rappelé que la puissance est égale au produit de la résistance électrique par le carré de l'intensité, le passage du courant produit ainsi un échauffement important dans la zone de résistance électrique élevée dite zone chaude. Inversement, étant donné que les zones froides présentent une résistance électrique la plus faible possible, il en résulte un dégagement de puissance thermique minime au niveau des connexions électriques.

En outre, la valeur de la résistance électrique étant égale au produit de la résistivité par la longueur du conducteur divisée par sa section, il est possible de modifier les valeurs de la résistance en faisant varier la valeur de l'un quelconque des paramètres précités : résistivité, longueur, section.

Dans une forme de réalisation d'éléments chauffants en couche mince, en utilisant par exemple la technique du dépôt sous vide, on peut faire intervenir au moins deux matériaux de résistivité différente, chacun étant déposé à travers des masques spécifiques pour constituer successivement une (zone chaude) partie chauffante sous forme de piste et un ou plusieurs collecteurs ou drains. Les deux matériaux sont sélectionnés en fonction de leurs résistivités intrinsèques, tandis que leurs sections sont déterminées en fonction des valeurs de conductance nécessaire aux zones froides et de la valeur de résistance nécessaire à la partie chauffante.

Lorsque le revêtement chauffant ne permet pas d'avoir une résistance électrique suffisamment élevée en ajustant l'épaisseur dudit revêtement, il devient nécessaire d'ajuster la longueur de la résistance déposée sous forme de pistes, afin, par conséquent, d'augmenter la longueur parcourue par le courant.

Comme indiqué précédemment, un second matériau, très conducteur, est déposé aux extrémités des résistances pour faire office de drain. On peut citer, par exemple, l'enseignement des brevets JP7226301 et JP8124707.

Dans une autre forme de réalisation, lorsque le dépôt résistif n'est pas en forme de piste, les connexions électriques peuvent être prises de part et d'autres du revêtement résistif par l'intermédiaire d'un revêtement conducteur réalisé en forme de bandes connues sous le nom de drains. Une telle solution ressort de l'enseignement des documents WO015821 WO03095251 et US4543466. Selon l'enseignement du document WO015821 la couche chauffante est réalisée dans un matériau transparent conducteur et est associée à une couche d'argent de forte conductivité électrique, afin d'assurer la fonction de drain, sans échauffement.

Il résulte de cet état de la technique, que l'élaboration d'un élément chauffant, par dépôt de couches minces, nécessite deux étapes :

- une première étape pour le dépôt de la résistance électrique au travers d'un masque dans le cas d'une résistance en forme de pistes ou, directement, sur la totalité de la surface du substrat. A noter que la fabrication des pistes peut également être réalisée en enlevant sélectivement le dépôt résistif ;
- une deuxième étape, pour le dépôt au travers d'un autre masque d'un autre revêtement, pour la réalisation des drains.

Il est donc nécessaire d'utiliser deux matériaux différents et une manipulation de masque entre les deux dépôts.

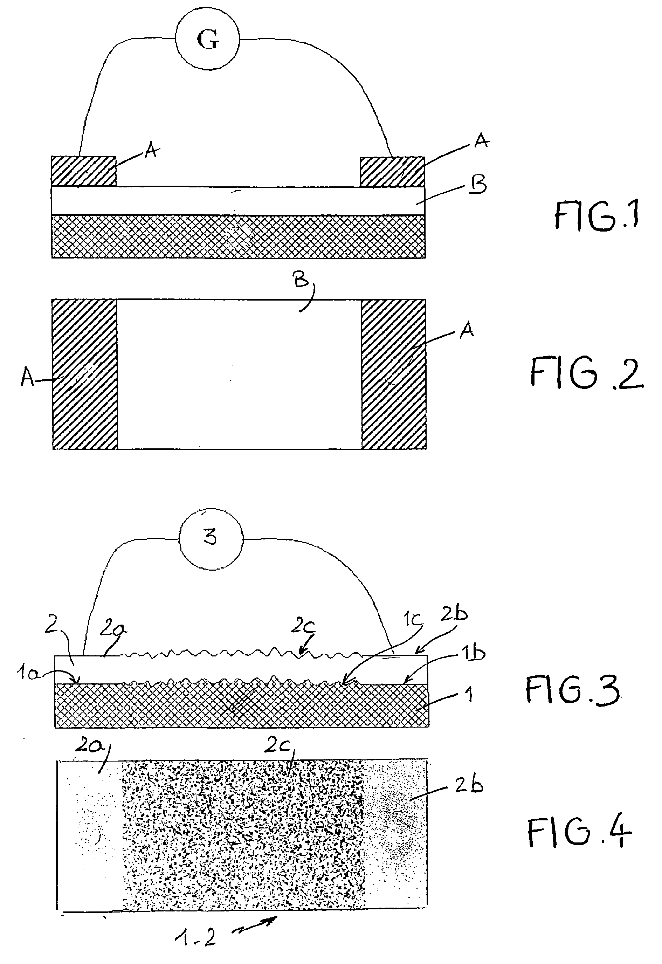

Cet état de la technique est illustré schématiquement à la figure 1 qui montre un élément chauffant réalisé en deux étapes. L'élément chauffant est constitué par un substrat (C) réalisé dans un matériau isolant électrique tel qu'une céramique, un verre ou une matière plastique... Sur la totalité de la surface du substrat (C), est déposé un revêtement (B) faiblement conducteur. Un masque est positionné sur le revêtement (B), de manière, par exemple, à ne pas recouvrir ses extrémités pour permettre le dépôt d'un second revêtement à forte conductivité, afin de réaliser les drains (A) pour la connexion d'une source d'alimentation électrique tel qu'un générateur (G).

A partir de cet état de la technique, le problème que se propose de résoudre l'invention est de réaliser, en une seule étape de dépôt et avec un seul matériau, des éléments chauffants en couches minces.

Pour résoudre un tel problème, il a été conçu et mis au point un procédé de fabrication d'un élément chauffant par dépôt de couches minces sur un substrat isolant selon lequel :

- on modifie l'état de la surface du substrat pour obtenir au moins une zone lisse de faible rugosité Ra et au moins une zone de rugosité plus élevée Rax ;
- on applique, sur les différentes zones, un matériau très conducteur de l'électricité ;
- on raccorde la ou les zones du matériau au niveau de la ou des zone lisses du substrat à une source d'alimentation électrique.

Il résulte de ce procédé que l'élément chauffant peut être obtenu en une seule étape de dépôt pour réaliser, en même temps, la résistance électrique et les drains constitués en l'espèce par les zones lisses à faible rugosité.

Il n'est donc plus nécessaire d'utiliser deux matériaux différents, ni d'appliquer des masques différents en cours de procédé d'élaboration des revêtements.

Contrairement aux connaissances générales de l'homme du métier, selon l'invention, le matériau fortement conducteur est utilisé, pour la partie chauffante, et non plus seulement pour les parties froides ou drains.

A partir de cette conception de base,

- soit on dépose la couche de matériau très conducteur sur l'ensemble du substrat, de manière à recouvrir la totalité des zones lisses et rugueuses ;
- soit on dépose la couche du matériau très conducteur, de manière à former une piste recouvrant une partie des zones lisses et une partie de la zone rugueuse.

Dans une forme de réalisation, on réalise la zone de rugosité plus élevée entre deux zones lisses.

L'invention concerne également un élément chauffant par dépôt de couches minces sur un substrat isolant présentant au moins une partie chauffante par effet Joule et au moins une partie de connexion électrique constituées par au moins une zone de rugosité plus élevée Rax et au moins une zone lisse de faible rugosité Ra , lesdites zones étant recouvertes d'une couche mince d'un matériau très conducteur, une source d'alimentation électrique étant connectée au niveau de la ou des zone(s) du matériau au niveau de la zone ou des zones lisse(s) du substrats.

Parmi les matériaux très conducteurs, susceptibles d'être utilisés, on peut citer, à titre indicatif nullement limitatif, l'aluminium, le cuivre, l'argent, l'or, et plus généralement tout matériau présentant une conductivité électrique intrinsèque supérieure à $30 \times 10^6$ S.m$^{-1}$ à température ambiante.

Selon une autre caractéristique, la rugosité Ra de la ou des zone(s) lisse(s) et inférieure à 0,5 $\mu$m.

Dans une forme de réalisation, le substrat présente une zone lisse de faible rugosité Ra disposée à côté d'une zone de rugosité plus élevée Rax.

Dans une autre forme de réalisation, le substrat présente deux zones lisses de faible rugosité Ra disposée de part et d'autre d'une zone de rugosité plus élevée Rax.

Comme il ressort du procédé :

- soit la couche mince de matériau très conducteur est déposée sur la totalité de la surface du substrat de manière à recouvrir les différentes zones ;
- soit la couche mince de matériau très conducteur est déposée sous forme d'une piste recouvrant les différentes zones.

Des résultats particulièrement avantageux ont été obtenus lorsque le rapport de résistance électrique R2/R1 est supérieur au rapport du carré des coefficients $\alpha 1$ et $\alpha 2$, soit R2 /R1 > $(\alpha 2)^2/(\alpha 1)^2$, formule dans laquelle :

R1 = résistance en ohm de la zone lisse de faible rugosité (Ra) ;
R2 = résistance en ohm de la zone de rugosité plus élevée (Rax) ;
$\alpha 1$ = longueur développée de la zone lisse divisée par sa longueur palpée au moyen d'un rugosimètre ;
$\alpha 2$ = longueur développée de la zone de rugosité plus élevée divisée par sa longueur palpée au moyen d'un rugosimètre.

L'invention est exposée ci-après plus en détail à l'aide des figures des dessins annexés dans lesquels :

- la figure 1 est une vue à caractère schématique d'un élément chauffant, selon l'état antérieur de la technique ;
- la figure 2 est une vue de dessus correspondant à la figure 1;
- la figure 3 est une vue en coupe à caractère schématique semblable à la figure 1 montrant l'élément chauffant obtenu selon l'invention ;
- la figure 4 est une vue en plan correspondant à la figure 3;
- les figures 5 et 6 sont des vues en plan à caractère schématique d'autres exemples de réalisation de l'élément chauffant dans lequel le revêtement très conducteur est déposé sous forme d'une piste ;

- la figure 7 est une vue en perspective à caractère schématique d'un élément avec une zone lisse et une zone rugueuse ;
- la figure 8 est une vue correspondant à la figure 7 après dépôt de revêtement sur l'extérieur de la zone cylindrique.

On a illustré aux figures 3 et 4 une première forme de réalisation d'éléments chauffants obtenus selon les caractéristiques de l'invention, sur un substrat isolant électrique (1) de tout type, connu et approprié.

Selon une caractéristique à la base de l'invention, on procède à la modification de l'état de surface du substrat (1), de manière à obtenir des zones lisses (1a) et (1b) de faible rugosité Ra, typiquement inférieure à 0,5 $\mu$m, et une zone (1c) de rugosité plus élevée Rax, nécessairement supérieure à 0,5 $\mu$m.

Sur la totalité de la surface du substrat (1), du côté des zones (1a), (1b) et (1c) est déposé un revêtement (2) constitué d'un matériau à forte conductibilité électrique. La conductivité du matériau très conducteur est supérieure à 30 $10^6$ S/m$^2$ à température ambiante. Ainsi, les zones (2a) et (2b) du matériau (2), au niveau des zones lisses (1a) et (1b) du substrat (1), constituent les drains pour la connexion d'une source d'alimentation électrique telle qu'un générateur (3), tandis que la zone (2c), au niveau de la zone (1c) de rugosité plus élevée, constitue la partie chauffante de l'élément.

L'ajustement de la résistance électrique s'effectue principalement en modifiant la rugosité de la zone (1c) du substrat. Il est aussi possible, de combiner les caractéristiques de la rugosité et de modifier l'épaisseur du revêtement afin d'ajuster la valeur de la résistance.

Le revêtement (2) peut être déposé sous forme de pistes, par exemple en positionnant un masque, avant le dépôt dudit revêtement ou en procédant à un enlèvement sélectif du revêtement.

Pour la réalisation de pistes, il s'est avéré important de privilégier des surfaces de faible rugosité, au niveau rayons de courbure des pistes, étant donné qu'une surface de faible rugosité favorise une résistance faible permettant de réduire l'échauffement et, par conséquent, d'éviter la destruction du dépôt.

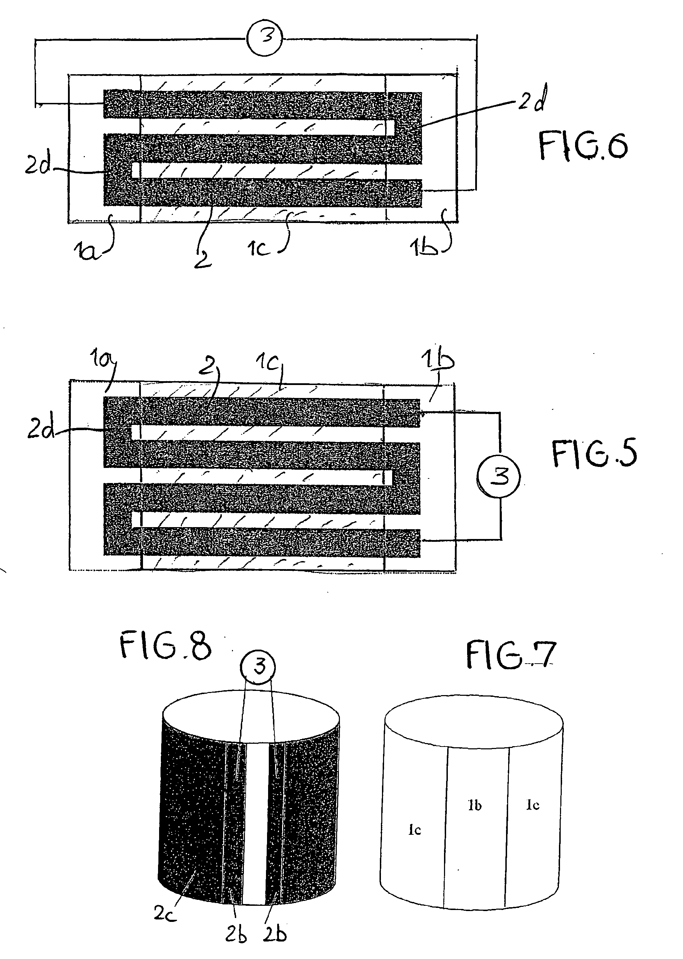

Une forme de réalisation avantageuse est illustrée à la figure 5 qui montre un substrat (1) présentant une zone centrale de rugosité Rax plus élevée (1c) et deux zones latérales (la) et (1b) de faible rugosité (Ra). La zone (la) où apparaissent les rayons de courbure (2d) des pistes (2) de faible rugosité, permet d'éviter la surchauffe, de même qu'au niveau des drains pour la connexion électrique du générateur (3).

Aux figures illustrées, le substrat présente deux zones lisses (la) et (1b) de faible rugosité Ra disposées de part et d'autre d'une zone de rugosité plus élevée Rax. Eventuellement, le substrat peut présenter une seule zone lisse de faible rugosité Ra disposée à côté d'une zone de rugosité plus élevée Rax. De même, les pistes (2d) constituées par le revêtement (2) à forte conductibilité électrique, peuvent présenter différentes formes de réalisation. On renvoie aux figures 5 et 6.

A la figure 7, le substrat présente une zone (1b) de faible rugosité et une zone (1c) de rugosité élevée. Le revêtement (2) est déposé sur l'extérieur de la zone cylindrique en (2c) (zone de rugosité élevée) et en (2b) (zone de faible rugosité) où est connecté le générateur électrique (3).

D'ores et déjà, on souligne, comme avantage, que, selon l'invention, la modification locale de l'état de surface du substrat, avant le dépôt du revêtement conducteur, permet de réaliser les éléments chauffants avec un seul matériau en forme de piste ou non.

Cette modification de l'état de surface peut être prévue en amont, lors de la fabrication du substrat, par exemple dans le cadre d'un substrat en polymère grâce à un relief que présente la surface d'un moule d'injection.

Ou bien, cette modification de l'état de surface peut être obtenue directement sur le substrat avant dépôt, en utilisant la technique connue de sablage ou tout autre moyen adapté à la modification de la rugosité du substrat considéré.

Dans le cas de substrats eux-mêmes conducteurs électriques, un premier revêtement isolant peut être appliqué avant le dépôt de l'élément chauffant.

A noter que l'on peut, pour réaliser les caractéristiques à la base de l'élément chauffant, selon l'invention :

- soit utiliser un substrat de faible rugosité Ra que l'on soumet à un traitement pour obtenir, par exemple, une zone de rugosité plus élevée Rax entre deux zones lisses de rugosité Ra ;
- soit utiliser un substrat de rugosité plus élevée Rax que l'on soumet à un traitement pour obtenir, par exemple, deux zones de faible rugosité Ra de part et d'autre d'une zone de rugosité plus élevée Rax.

On renvoie aux trois exemples ci-après :

Exemple 1 :

Dans l'exemple 1, on a effectué des dépôts de cuivre sur des substrats en polycarbonate en utilisant la technique de dépôt sous vide.

Les substrats de polycarbonate, sous formes de bandes, ont une valeur de rugosité initiale de Ra = 0,02 $\mu$m. Ces substrats en polycarbonate, ont subi un sablage avant dépôt sous vide, ce qui a porté leur rugosité à Ra = 4,9 $\mu$m.

Les extrémités de ces bandes ont été conservées lisses pour assurer la fonction de contact électrique et la répartition homogène du courant.

Sur chaque état de surface, 3 types de résistances ont été élaborées. La longueur des résistances est de 98 mm, leurs largeurs sont respectivement de 5, 12 et 24 mm. Les profils de rugosité ont permis de calculer la longueur développée pour chaque état de surface.

Les résistances électriques ont été caractérisées en imposant un courant électrique et en mesurant la tension aux bornes de la résistance. Tous les substrats sont revêtus simultanément dans l'équipement de dépôt sous vide. Par ailleurs, les substrats sont positionnés de façon identique par rapport à la source de dépôt.

Sur des substrats témoins de verre dont la rugosité Ra est inférieure à 0,01 $\mu$m, l'épaisseur des dépôts de cuivre a été mesurée à 1,15 $\mu$m.

Les éprouvettes rugueuses sont élaborées suivant le principe des figures 3 et 4.

| Largeur résistance | Ra ($\mu$m) | I (A) | U (V) | R = U/I (Ohm) | R2/R1 | $\alpha$ mesuré | $\alpha \times \alpha$ | $(\alpha 2 \times \alpha 2)/(\alpha 1 \times \alpha 1)$ |
|---|---|---|---|---|---|---|---|---|
| 24 mm | 0,02 | 3 | 1,162 | R1 = 0,387 | 3,2 | $\alpha 1$ =1,0004 | 1,0008 | 1,2 |
|  | 4,86 | 1 | 1,245 | R2 = 1,245 |  | $\alpha 2$=1,0841 | 1,1752 |  |
| 12 mm | 0,02 | 2 | 1,489 | R1 = 0,745 | 3,2 | $\alpha 1$ = 1,0004 | 1,0008 | 1,2 |
|  | 4,86 | 1 | 2,400 | R2 = 2,400 |  | $\alpha 2$ = 1,0841 | 1,1752 |  |
| 5 mm | 0,02 | 1 | 1,705 | R1 = 1,705 | 3,1 | $\alpha 1$ = 1,0004 | 1,0008 | 1,2 |
|  | 4,86 | 1 | 5,225 | R2 = 5,225 |  | $\alpha 2$ = 1,0841 | 1,1752 |  |

$\alpha$ représente la longueur développée divisée par la longueur palpée à l'aide d'un rugosimètre. Dans le tableau, les surfaces rugueuses ont été indicées 2 et les surfaces lisses, indicées 1.

$\alpha$ = dimension développée / dimension apparente

Il est évident que la rugosité a pour effet d'augmenter la longueur et la largeur développée d'une surface.

La valeur de la résistance électrique $R_i$ s'exprime de la façon générale suivante :

$$R_i = \rho \times L \times \alpha_i / ((e/(\alpha_i \times \alpha_i)) \times l \times \alpha_i) = \rho \times L \times \alpha_i \times \alpha_i / (e \times l)$$

La longueur ($L_i$) développée de la surface i vaut $L \times \alpha_i$, la largeur ($l_i$) de la surface i vaut $l \times \alpha_i$, et l'épaisseur ($e_i$) du dépôt sur une surface i devient $e/(\alpha_i \times \alpha_i)$, de sorte que le volume (V) du dépôt reste inchangé. $V = V_i = L x \alpha_i \times l \times \alpha_i \times e/(\alpha_i \times \alpha_i) = Lxlxe$

Ceci aboutit à la conclusion que le rapport de résistances électriques (R2/R1) devrait être égal, pour l'homme du métier, au rapport du carré des coefficients $\alpha$ (R2/R1 = $(\alpha 2 \times \alpha 2)/ (\alpha 1 \times \alpha 1)$).

Les résultats expérimentaux montrent que pour les 3 largeurs de résistances électriques, les zones rugueuses conduisent à une augmentation de la résistance électrique selon un rapport R2/R1 compris entre 3,1 et 3,2.

Un tel facteur d'augmentation rend l'utilisation de matériaux très conducteurs, possible en tant que résistance électrique, alors que sur les zones lisses, les dépôts se comportent comme un court circuit et sont inutilisables en tant qu'éléments chauffants.

Les résultats montrent également que l'augmentation de la valeur de résistance électrique ne découle pas principalement des effets géométriques de la rugosité, puisque le rapport R2/R1 est, de façon inattendue, très nettement supérieur au rapport des carrés des coefficients $\alpha$. Par ailleurs, l'homme de l'art, en partant d'une approche théorique ne serait pas incité à intervenir sur la rugosité puisqu'une augmentation de la résistance électrique d'un facteur de seulement 1,2 ne permet pas de passer de la situation d'un court circuit à celle d'une résistance chauffante.

Exemple 2 :

Dans l'exemple 2, on a effectué les mêmes dépôts que dans l'exemple 1 sur du polysulfone par technique de dépôt sous vide. Les éprouvettes rugueuses sont élaborées suivant le principe des figures 3, 4 et 5. La longueur des résistances est de 45 mm, leurs largeurs sont de 12 et 23 mm.

| Substrat | Largeur résistance | Ra (μm) | R = U/I (Ohm) | R2/R1 | α mesuré | α×α | (α2×α2)/(α1×α1) |
|---|---|---|---|---|---|---|---|
| Polysulfone | 23 mm | 0,08 | R1 = 0,293 | 4,9 | α1 = 1,0008 | 1,0016 | 1,2 |
| | | 6,04 | R2 = 1,430 | | α2 = 1,1001 | 1,2102 | |
| | 12 mm | 0,08 | R1 = 0,441 | 5,5 | α1 = 1,0008 | 1,0016 | 1,2 |
| | | 6,04 | R2 = 2,450 | | α2 = 1,1001 | 1,2102 | |

Dans cet exemple, on constate également que l'accroissement de résistance électrique ne suit pas l'effet géométrique dû à la rugosité. Le changement de longueur développé n'explique pas l'accroissement de la résistance.

Exemple 3 :

Dans cet exemple, des résistances chauffantes ont été élaborées sur des pièces en polycarbonate. Un masque a été positionné sur les éprouvettes avant dépôt de sorte à obtenir des pistes.

A titre de comparaison, 4 pièces (élément chauffant) ont été réalisées.

Pour la pièce 1, l'état de surface du substrat n'a pas été modifié, le Ra est de 0,02 μm.

Pour la pièce 2, l'état de surface a été modifié sur l'intégralité de la surface du substrat, le Ra est de 4,92 μm.

Pour la pièce 3, l'état de surface du substrat n'a pas été modifié au niveau des virages et au niveau des contacts électriques, le Ra étant dans ces zones de 0,02 μm.

Au niveau des pistes, la rugosité a été augmentée par sablage pour porter la rugosité de 0,02 μm à 4,89 μm. La pièce 3 est réalisée suivant le principe des figures 3, 4 et 5.

Sur ces trois premières pièces, un dépôt de cuivre a été réalisé par PVD. L'épaisseur de ce dépôt à été mesuré sur les zones lisses de Ra = 0,02 μm et est de 0,5 μm.

Pour la pièce 4, réalisée selon le principe de l'état de la technique (figures 1 et 2), la surface de la pièce présente une rugosité de 0,02 μm. Un premier dépôt d'alliage NiCr résistif de 0,1 μm a été élaboré au travers du premier masque. Après ce premier dépôt, un second masque a été appliqué sur la pièce qui a ensuite subi un dépôt 0,5 μm de cuivre sur les zones d'extrémité telles que définies sur la figure 5.

Après détermination de la résistance électrique globale, les résistances ont été alimentées sous 12V afin de mesurer l'échauffement par effet Joule. La température ambiante est de 20°C pendant les mesures de l'échauffement.

| pièce | R globale | T équilibre en °C | Observation |
|---|---|---|---|
| 1 | 3,2 Ohm | N D | Non conforme : Destruction du substrat par surchauffe. |
| 2 | 11,2 ohm | N D | Non conformé: Destruction des contacts électriques |
| 3 | 10,0 Ohm | 65°C | Conforme |
| 4 | 10,3 Ohm | 63°C | Non conforme: 2 matériaux en 2 étapes |

Il en résulte que :

- La pièce 1 est non conforme, l'état de surface trop lisse conduit à une résistance très basse de telle sorte que lorsque la résistance est alimentée sous 12V, l'échauffement excessif résultant du fort ampérage produit la détérioration du substrat par échauffement au-delà de 150°C sa température de transition vitreuse.

- La pièce 2 est non conforme, l'échauffement au niveau des contacts électriques, où les lignes de courant sont très denses, produit la destruction du dépôt et du substrat au niveau de ces contacts.

- La pièce 3 est conforme, sa valeur de résistance limite le passage de courant, de sorte que la température s'élève à une valeur permettant une application telle que le dégivrage ou le désembuage, sans conduire à la destruction du support. Au niveau des contacts électriques et des virages de la structuré en pistes, où la densité de courant est importante, les surfaces lisses permettent une résistance basse évitant les surchauffes locales.

- Enfin, la pièce 4 est non conforme malgré le fait qu'elle puisse être utilisée comme élément chauffant. En effet, la structure a été obtenue en utilisant 2 matériaux de conductivité très différente et en procédant au dépôt en 2 étapes avec interposition d'un masque entre ces 2 étapes, ce qui correspond à l'état de la technique avec les inconvénients en résultant que l'on a voulu supprimer.

Les avantages ressortent bien de la description. En particulier, on souligne et on rappelle la possibilité d'obtenir un élément chauffant en une seule étape et avec un seul matériau pour réaliser à la fois la résistance électrique et les drains.

## Revendications

1. Procédé de fabrication d'un élément chauffant par dépôt de couches minces sur un substrat isolant (1) selon lequel :

   - on modifie l'état de la surface du substrat (1) pour obtenir au moins une zone lisse (1a,1b) de faible rugosité Ra et au moins une zone (1c) de rugosité plus élevée Rax ;
   - on applique, sur les différentes zones (1a), (1b), (1c), un matériau (2) très conducteur de l'électricité ;
   - on raccorde la ou les zones (2a,2b) du matériau (2) au niveau de la ou des zones lisses (1a, 1b) du substrat à une source d'alimentation électrique (3).

2. Procédé selon la revendication 1, **caractérisé en ce qu'**on dépose la couche de matériau très conducteur (2) sur l'ensemble du substrat (1), de manière à recouvrir la totalité des zones lisses (1a, 1b) et rugueuses (1c).

3. Procédé selon la revendication 1, **caractérisé en ce qu'**on dépose la couche du matériau très conducteur (2), de manière à former une piste recouvrant une partie des zones lisses (1a, 1b) et une partie de la zone rugueuse (1c).

4. Procédé selon l'une quelconque des revendications 1 à 3, **caractérisé en ce qu'**on réalise la zone de rugosité plus élevée (1c) entre deux zones lisses (1a, 1b).

5. Elément chauffant par dépôt de couches minces sur un substrat isolant (1) présentant au moins une partie-chauffante électriquement et au moins une partie de connexion électrique, **caractérisé en ce que** lesdites parties sont constituées par au moins une zone lisse (1a, 1b) de faible rugosité Ra et au moins une zone (1c) de rugosité plus élevée Rax, lesdites zones (1a), (1b), (1c) étant recouvertes d'une couche mince d'un matériau très conducteur (2), une source d'alimentation électrique (3) étant connectée au niveau de la ou des zones (2a, 2b) du matériau (2) au niveau de la ou des zones lisses (1a, 1b) du substrat

6. Elément selon la revendication 5, **caractérisé en ce que** la rugosité Ra de la ou des zone(s) lisse(s) est inférieure à 0,5 $\mu$m.

7. Elément selon la revendication 5, **caractérisé en ce que** le substrat (1) présente une zone lisse de faible rugosité Ra disposée à côté d'une zone de rugosité plus élevée Rax.

8. Elément selon la revendication 5, **caractérisé en ce que** le substrat présente deux zones lisses de faible rugosité Ra disposées de part et d'autre d'une zone de rugosité plus élevée Rax.

9. Elément selon l'une des revendications 5 à 8, **caractérisé en ce que** la couche mince de matériau très conducteur (2) est déposée sur la totalité de la surface du substrat de manière à recouvrir les différentes zones (1a), (1b), (1c).

10. Elément selon l'une des revendications 5 à 8, **caractérisé en ce que** la couche mince de matériau très conducteur (2) est déposée sous forme d'une piste recouvrant les différentes zones (1a), (1b), (1c).

11. Elément selon l'une quelconque des revendications 5 à 10, **caractérisé en que** la conductivité du matériau très conducteur est supérieure à 30 $10^6$ S/m$^2$ à température ambiante.

12. Elément selon l'une des revendications 5 à 11, **caractérisé en ce que** le matériau très conducteur (2) est du cuivre, ou de l'aluminium, ou de l'argent, ou de l'or.

13. Elément selon l'une des revendications 5 à 11, **caractérisé en ce que** le substrat (1) est réalisé dans un matériau isolant.

**14.** Elément selon l'une des revendications 5 à 11, **caractérisé en ce que** le substrat (1) est réalisé dans un matériau conducteur revêtu d'une couche isolante

**15.** Elément selon l'une des revendications 5 à 14, **caractérisé en ce que** le rapport de résistance électrique R2/R1 est supérieur au rapport du carré des coefficients $\alpha1$ et $\alpha2$, soit $R2/R1 > (\alpha2)^2 / (\alpha1)^2$, formule dans laquelle :

R1 = résistance en ohm de la zone lisse de faible rugosité Ra ;
R2 = résistance en ohm de la zone rugosité plus élevée Rax ;
$\alpha1$ = longueur développée de la zone lisse divisée par sa longueur palpée au moyen d'un rugosimètre ;
$\alpha2$ = longueur développée de la zone de rugosité plus élevée divisée par sa longueur palpée au moyen d'un rugosimètre.

**16.** Utilisation de l'élément chauffant selon l'une quelconque des revendications 5 à 15 pour le désembuage, le dégivrage de surfaces réfléchissantes.

## Claims

**1.** Method of manufacturing a heating element by deposition of thin films on an insulating substrate (1) wherein:

- the state of the surface of the substrate (1) is modified to give at least one smooth zone (1a, 1b) of slight roughness Ra and at least one zone (1c) of greater roughness Rax;
- a material (2) highly conductive of electricity is applied to the different zones (1a), (1b), (1c);
- the zone or zones (2a, 2b) of the material (2) are connected to an electric supply source (3) in the region of the smooth zone or zones (1a, 1b) of the substrate.

**2.** Method as claimed in claim 1, **characterised in that** the film of highly conductive material (2) is deposited on the whole of the substrate (1), so as to cover the smooth (1a, 1b) and rough (1c) zones in their entirety.

**3.** Method as claimed in claim 1, **characterised in that** the film of highly conductive material (2) is deposited, so as to form a track covering a part of the smooth zones (1a, 1b) and a part of the rough zone (1c).

**4.** Method as claimed in any one of claims 1 to 3, **characterised in that** the zone of greatest roughness (1c) is implemented between two smooth zones (1a, 1b).

**5.** Heating element by deposition of thin films on an insulating substrate (1) that has at least one electrically heating part and at least one electrical connection part, **characterised in that** said parts are constituted by at least one smooth zone (1a, 1b) of slight roughness Ra and at least one zone (1c) of greater roughness Rax, said zones (1a), (1b), (1c) being covered with a thin film of a highly conductive material (2), an electrical supply source (3) being connected to the zone or zones (2a, 2b) of the material in the region of the smooth zone or zones (1a, 1b) of the substrate.

**6.** Element as claimed in claim 5, **characterised in that** the roughness Ra of the smooth zone or zones is less than 0.5 $\mu$m.

**7.** Element as claimed in claim 5, **characterised in that** the substrate (1) has a smooth zone of slight roughness Ra placed next to a zone of greater roughness Rax.

**8.** Element as claimed in claim 5, **characterised in that** the substrate has two smooth zones of slight roughness Ra placed on either side of a zone of greater roughness Rax.

**9.** Element as claimed in one of claims 5 to 8, **characterised in that** the thin film of highly conductive material (2) is deposited over the entire surface of the substrate so as to cover the different zones (1a), (1b), (1c).

**10.** Element as claimed in one of claims 5 to 8, **characterised in that** the thin layer of highly conductive material (2) is deposited in the form of a track covering the different zones (1a), (1b), (1c).

**11.** Element as claimed in any one of claims 5 to 10, **characterised in that** the conductivity of the highly conductive material is greater than 30 $10^6$ S/m$^2$ at ambient temperature.

**12.** Element as claimed in one of claims 5 to 11, **characterised in that** the highly conductive material (2) is copper, or aluminium, or silver, or gold.

**13.** Element as claimed in one of claims 5 to 11, **characterised in that** the substrate (1) is made out of an insulating material.

**14.** Element as claimed in one of claims 5 to 11, **characterised in that** the substrate (1) is made out of a conductive material coated with an insulating film.

**15.** Element as claimed in one of claims 5 to 14, **characterised in that** the electrical resistance ratio R2/R1 is greater than the ratio of the square of the coefficients α1 and α2, i.e. R2 /R1 > $(\alpha2)^2$ / $(\alpha1)^2$, a formula wherein:

R1 = resistance in ohms of the smooth zone of slight roughness Ra;
R2 = resistance in ohms of the zone of greater roughness Rax;
α1 = developed length of the smooth zone divided by its length scanned using a surface roughness tester;
α2 = developed length of the zone of greater roughness divided by its length scanned using a surface roughness tester.

**16.** Use of the heating element as claimed in any one of claims 5 to 15 for the demisting or de-icing of reflecting surfaces

**Patentansprüche**

**1.** Verfahren zur Herstellung eines Heizelements durch Aufbringung von dünnen Schichten auf ein isolierendes Substrat (1), bei dem:

- der Oberflächenzustand des Substrats (1) verändert wird, um mindestens eine glatte Zone (1a, 1b) mit geringer Rauigkeit Ra und mindestens eine Zone (1c) mit höherer Rauigkeit Rax zu erhalten;
- auf die verschiedenen Zonen (1a), (1b), (1c), ein sehr stromleitfähiges Material (2) aufgebracht wird;
- die Zone(n) (2a, 2b) des Materials (2) im Bereich der glatten Zone(n) (1a, 1b) des Substrats mit einer Stromquelle (3) verbunden wird(werden).

**2.** Verfahren nach Anspruch 1, **dadurch gekennzeichnet, dass** die Schicht des sehr leitfähigen Materials (2) so auf das gesamte Substrat (1) aufgetragen wird, um die Gesamtheit der glatten (1a, 1b) und rauen (1c) Zonen zu überziehen.

**3.** Verfahren nach Anspruch 1, **dadurch gekennzeichnet, dass** die Schicht des sehr leitfähigen Materials (2) so aufgetragen wird, um eine Bahn zu bilden, die einen Teil der glatten Zonen (1a, 1b) und einen Teil der rauen Zone (1c) überzieht.

**4.** Verfahren nach einem der Ansprüche 1-3, **dadurch gekennzeichnet, dass** die Zone mit höherer Rauigkeit (1c) zwischen zwei glatten Zonen (1a, 1b) angelegt wird.

**5.** Heizelement durch Auftrag von dünnen Schichten auf ein isolierendes Substrat (1) mit mindestens einem elektrisch heizenden Teil und mindestens einem Teil mit elektrischem Anschluss, **dadurch gekennzeichnet, dass** die besagten Teile aus mindestens einer glatten Zone (1a, 1b) mit geringer Rauigkeit Ra und mindestens einer Zone (1c) mit höherer Rauigkeit Rax bestehen, wobei die besagten Zonen (1a), (1b), (1c) mit einer dünnen Schicht eines sehr leitfähigen Materials (2) überzogen sind und im Bereich der Zone(n) im Bereich der glatten Substratzone(n) (1a, 1b) des Materials eine Stromquelle (3) angeschlossen ist.

**6.** Element nach Anspruch 5, **dadurch gekennzeichnet**, das die Rauigkeit Ra der glatten Zone geringer ist als 0,5 μm.

**7.** Element nach Anspruch 5, **dadurch gekennzeichnet, dass** das Substrat (1) eine glatte Zone mit geringer Rauigkeit Ra aufweist, die neben einer Zone mit höherer Rauigkeit Rax angeordnet ist.

**8.** Element nach Anspruch 5, **dadurch gekennzeichnet, dass** das Substrat zwei glatte Zonen mit geringer Rauigkeit Ra aufweist, die beiderseits einer Zone mit der höheren Rauigkeit Rax angeordnet sind.

9. Element nach einem der Ansprüche 5-8, **dadurch gekennzeichnet, dass** die dünne Schicht mit sehr leitfähigem Material (2) so auf die gesamte Oberfläche des Substrats aufgetragen wird, um die verschiedenen Zonen (1a), (1b), (1c) zu überziehen.

10. Element nach einem der Ansprüche 5-8, **dadurch gekennzeichnet, dass** die dünne Schicht mit sehr leitfähigem Material (2) in Form einer Bahn aufgetragen wird, die die verschiedenen Zonen (1a), (1b), (1c) überzieht.

11. Element nach einem der Ansprüche 5-10, **dadurch gekennzeichnet, dass** die Leitfähigkeit des stark leitenden Materials bei Raumtemperatur höher ist als 30 $10^6$ S/m$^2$.

12. Element nach einem der Ansprüche 5-11, **dadurch gekennzeichnet, dass** das sehr leitfähige Material (2) Kupfer, Aluminium, Silber oder Gold ist.

13. Element nach einem der Ansprüche 5-11, **dadurch gekennzeichnet**, das das Substrat (1) aus einem isolierenden Material besteht.

14. Element nach einem der Ansprüche 5-11, **dadurch gekennzeichnet**, das das Substrat (1) aus einem leitfähigen Material besteht, das mit einer isolierenden Schicht überzogen ist.

15. Element nach einem der Ansprüche 5-14, **dadurch gekennzeichnet, dass** das elektrische Widerstandsverhältnis R2/R1 größer ist als das Quadrat der Koeffizienten $\alpha$1 und $\alpha$2, d.h. R2 /R1 > ($\square$2)$^2$ / ($\square$1)$^2$, wobei:

   R1 = Widerstand in Ohm der glatten Zone mit geringer Rauigkeit Ra;
   R2 = Widerstand in Ohm der Zone mit höherer Rauigkeit Rax;
   $\alpha$1 = abgewickelte Länge der glatten Zone geteilt durch ihre mit einem Rauigkeitsmesser ertasteten Länge;
   $\alpha$2 = abgewickelte Länge der Zone mit höherer Rauigkeit geteilt durch ihre mit einem Rauigkeitsmesser ertasteten Länge.

16. Verwendung des Heizelements nach einem der Ansprüche 5-15 zum Entnebeln oder Abtauen von reflektierenden Flächen.

FIG.1

FIG.2

FIG.3

FIG.4

FIG.6

FIG.5

FIG.8

FIG.7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 7226301 B
- JP 8124707 B
- WO 015821 A
- WO 03095251 A
- US 4543466 A